# FASCICULE DE BREVET EUROPEEN

(11) **EP 0 917 688 B1**
(45) Date de publication et mention de la délivrance du brevet: **28.06.2000**
(21) Numéro de dépôt: 97936722.4
(22) Date de dépôt: 31.07.1997
(51) Int. Cl.: G06K 19/077

(54) **CARTE A CIRCUIT INTEGRE A CONNEXION MIXTE**
KOMBINIERTE CHIPKARTE
INTEGRATED CIRCUIT CARD WITH TWO CONNECTION MODES

(30) Priorité: 02.08.1996 FR 9609802; 20.09.1996 FR 9611488
(43) Date de publication de la demande: 26.05.1999
(73) Titulaire: SCHLUMBERGER Systèmes, 92120 Montrouge (FR)
(72) Inventeur: THEVENOT, Benoît, F-45160 Olivet (FR); BILLEBAUD, Pascal, F-45000 Orléans (FR); BITSCHNAU, Thierry, F-60300 Senlis (FR); FLETOUT, Christophe, F-45000 Orléanss (FR)
(74) Mandataire: Fruchard, Guy
(86) Numéro de dépôt international: FR9701434
(87) Numéro de publication internationale: WO9806063

(56) Documents cités:
- EP-A- 0 671 705
- EP-A- 0 682 321
- WO-A-97/05569
- DE-A- 19 500 925
- DE-C- 4 403 753
- DE-C- 19 505 245
- FR-A- 2 726 106

## Description

La présente invention concerne une carte à circuit intégré à connexion mixte.

On entend par carte à connexion mixte une carte pouvant être reliée avec un appareil soit par une liaison avec contact, c'est-à-dire une liaison galvanique par des plages de contact affleurant la surface externe de la carte, soit par une liaison sans contact. Pour la liaison sans contact la carte comporte un élément de couplage sans contact tel qu'une boucle d'induction, une antenne radio ou un organe de couplage optique relié par un circuit de liaison noyé dans la carte à une interface généralement contenue dans le circuit intégré.

On connaît du document EP 682 321 une carte à circuit intégré à connexion mixte comportant un corps de carte dans lequel est noyée une antenne reliée à un module comprenant un circuit intégré relié à des plages conductrices portées par un film support, l'antenne ayant des extrémités à L'aplomb des plages conductrices. Ce document prévoit la mise en contact directe des plages conductrices du module avec les extrémités de l'antenne. Ceci pose un problème de positionnement du module qui doit être extrêmement précis et est donc incompatible avec une fabrication à cadence élevée.

FR-A-2 726 106 divulgue une carte à circuit intégré avec les caractéristiques du préambule de la revendication 1.

La présente invention est définie par la revendication 1.

Les caractéristiques et avantages de l'invention apparaîtront à la lecture de la description qui va suivre de nombreux modes de réalisation particuliers non limitatifs de l'invention qui relèvent tous de cette même idée inventive, en référence aux figures ci-jointes parmi lesquelles:
- la figure 1 est une vue en perspective éclatée des feuilles constituant le corps de la carte,
- la figure 2 est une vue partielle en coupe agrandie selon la ligne II-II de la figure 1 dans une étape intermédiaire de réalisation de la carte,
- la figure 3 est une vue en coupe analogue à celle de la figure 2 dans une étape ultérieure,
- la figure 4 est une vue en perspective partiellement écorchée d'un module à circuit intégré,
- la figure 5 est une vue en coupe analogue à celle de la figure 2, après mise en place du module à circuit intégré,
- la figure 6 illustre une variante de réalisation en relation avec le premier mode de réalisation,
- les figures 7 à 19 sont des vues en coupe partielles de différents autres exemples.

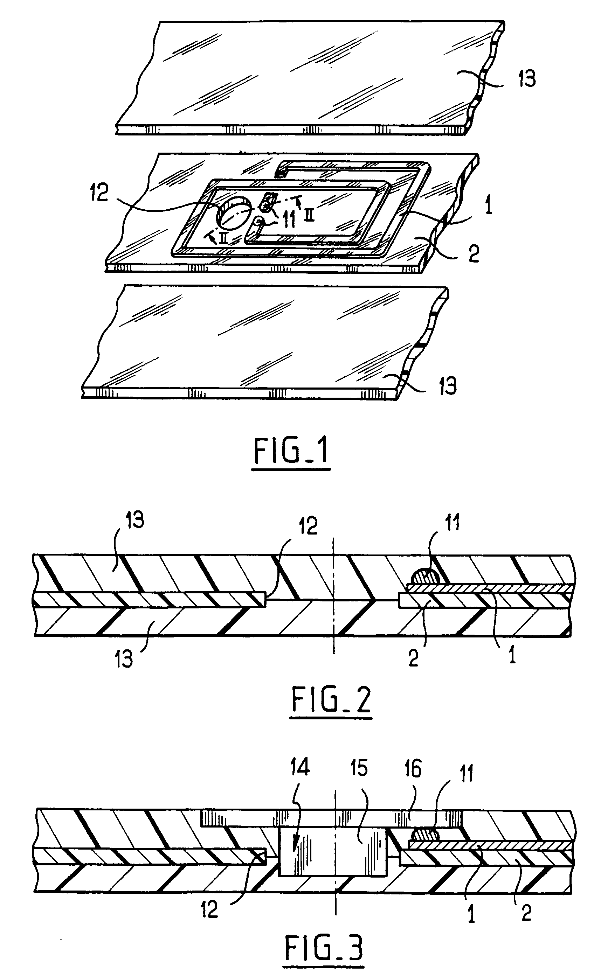

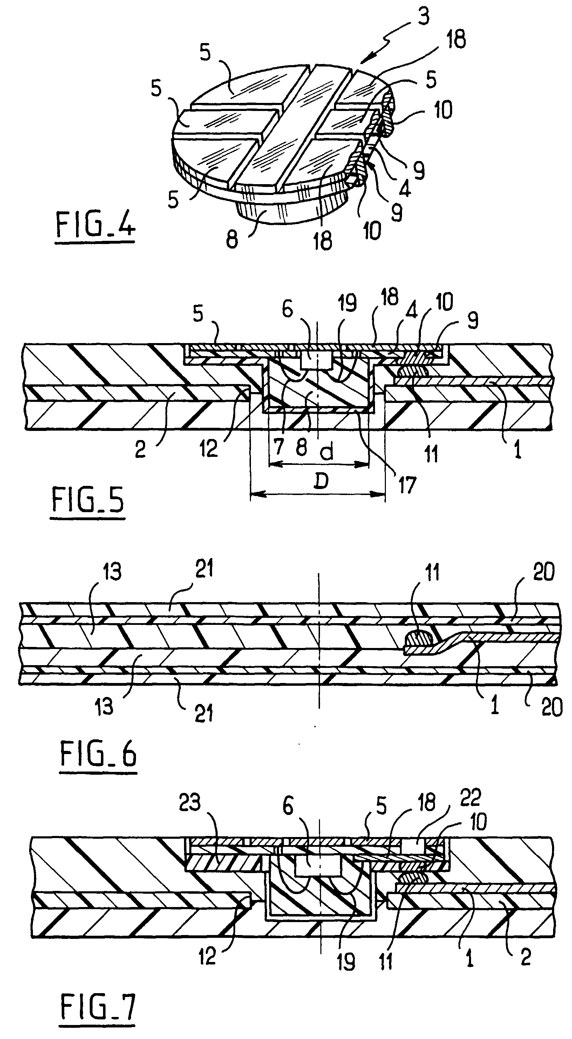

En référence aux figures 1 à 6, dans le premier exemple la carte à circuit intégré à connexion mixte est réalisée à partir d'un élément de couplage sans contact se présentant sous forme d'une antenne 1 portée par une feuille support 2 et d'un module, généralement désigné en 3 comprenant (voir figures 4 et 5) un film support 4 équipé de plages conductrices 5 reliées à un circuit intégré 6 par des fils 7 pour assurer une liaison avec contact, et des plages conductrices 18 reliées au circuit intégré 6 par des fils 19 pour assurer la liaison avec une interface sans contact incluse dans le circuit intégré 6. Le circuit intégré 6 et les fils de liaison 7 et 19 sont noyés dans un bloc de résine 8.

L'antenne 1 comporte deux extrémités adjacentes l'une à l'autre formant un circuit de liaison de l'élément de couplage sans contact que constitue l'antenne avec les plages conductrices 18 du module. Dans le cas d'un élément de couplage optique ce circuit de liaison sera constitué par des pistes conductrices s'étendant de manière analogue sur une feuille support. Le circuit de liaison sera par exemple constitué de pistes en cuivre réalisées selon la technique traditionnelle des circuits imprimés.

Dans ce premier exemple, des plots de liaison 11 sont formés sur les extrémités de l'antenne et s'étendent en saillie par rapport aux extrémités de l'antenne (voir figure 2). Les plots de liaison il peuvent être réalisés par sérigraphie d'un polymère conducteur ou par dépôt mécanique d'une goutte de métal. Ils peuvent également être réalisés sous forme d'un dépôt électrolytique, en collant (par une colle conductrice) ou en soudant un plot métallique sur le circuit imprimé de liaison, ou encore par attaque chimique ou usinage mécanique d'une piste épaisse.

Dans cet exemple les plages conductrices 18 sont portées par la face externe du module 3. Le film support 4 du module à circuit intégré 3 comporte en regard des plages de contact 18 des trous 9 pourvus de plots de connexion 10, par exemple une matière conductrice comprenant un polymère contenant des grains conducteurs, s'étendant en saillie sur une face du film support 4 opposée aux plages de contact 18. Dans le cas de plots de connexion 10 en matière conductrice, celle-ci est de préférence dans un état plastique avant l'incorporation du module à la carte à circuit intégré selon l'invention.

Afin de permettre une liaison entre les plages conductrices 18 du module et les extrémités de l'antenne 1, les trous 9 dans le film support du module sont réalisés selon une disposition permettant leur mise en regard des plots de liaison 11 lorsque le module à circuit intégré 3 est implanté dans la carte.

Dans l'exemple illustré, la feuille support 2 de l'antenne 1 est réalisée en une matière synthétique renforcée, par exemple une résine époxy renforcée par des fibres de verre ou des fibres polyester et l'antenne 1 est réalisée sous forme d'un circuit imprimé sur la feuille support 2. Dans ce mode de réalisation la feuille support 2 comporte une ouverture 12 ayant une dimension transversale D supérieure à la dimension transversale d du bloc de résine 8 contenant le circuit intégré 6 (figure 5).

Pour la réalisation de la carte telle qu'illustrée sur la figure 5, la feuille support 2 de l'antenne 1 est tout d'abord recouverte sur ses deux faces avec des feuilles de matière isolante 13. Des feuilles de matière thermoplastique telles que du PVC sont par exemple appliquées sur la feuille support 2 par laminage à chaud de sorte que les feuilles de matière isolante 13 adhèrent à la feuille support 2 et fluent pour remplir de façon homogène l'ouverture 12 dans la feuille support 2. La matière remplissant l'ouverture 12 assure en outre un encastrement de la feuille support 2 dans la masse de matière thermoplastique formée par le ramollissement des feuilles 13. On obtient ainsi la structure en sandwich représentée en coupe sur la figure 2.

Une cavité généralement désignée en 14 est ensuite creusée dans le corps de carte ainsi constitué (figure 3). La cavité 14 comporte une partie centrale 15 de faible diamètre mais de forte profondeur destinée à recevoir le bloc de résine 8 du module 3, et une partie périphérique 16 de plus grand diamètre et de plus faible profondeur destinée à recevoir le film support 4 et les plages conductrices 5 du module 3. On notera à ce propos que la hauteur des plots de liaison 11 est prévue pour que lors de la réalisation de la partie 16 de la cavité 14 les plots de liaison 11 de l'antenne débouchent dans le fond de la cavité. La réalisation de plots de liaison en saillie par rapport aux extrémités de l'antenne permet un usinage de la cavité avec des tolérances habituelles sans risquer d'endommager l'antenne. A ce propos on notera que compte tenu de la précision de positionnement du circuit de liaison sur sa feuille support et des tolérances de réalisation de la cavité, une surépaisseur de seulement 70 micromètres s'avère actuellement suffisante.

En outre on remarquera que la réalisation dans la feuille support 2 d'une ouverture 12 ayant une dimension transversale supérieure à la dimension transversale du bloc de résine du module 3 permet de réaliser la cavité dans une masse de matière homogène, ce qui permet d'utiliser un outil particulièrement adapté à cette matière. En outre, la matière thermoplastique homogène qui entoure la partie 15 de la cavité réalise un encastrement du bord de l'ouverture 12 de la feuille support 2, ce qui assure une meilleure résistance de la carte aux efforts auxquels elle est soumise lors des différentes manipulations que ce soit pendant la fabrication ou lors de l'utilisation. Les feuilles 13 ont de préférence des épaisseurs déterminées pour qu'après laminage l'antenne 1 soit au voisinage de la fibre neutre de la carte. On évite ainsi des phénomènes de cintrage du corps de carte qui résultent d'une dilatation différentielle lorsque l'antenne 1 n'est pas sur la fibre neutre. L'antenne 1, ou le circuit de liaison de l'élément de couplage sans contact, peuvent également être réalisés directement sur une feuille de matière thermoplastique. A ce propos on remarquera toutefois que lors du laminage les plots 11 réalisent une masse inhomogène qui tend à se déplacer vers le centre de la carte comme illustré par la figure 6 sous l'effet de la pression'sur la matière plastique en cours de fluage. Cette déformation provoque un fluage plus important de la matière thermoplastique à l'aplomb des plots 11. Il en résulte une déformation du décor généralement imprimé sur les faces externes des feuilles 13. Pour éviter cette déformation on prévoit donc de façon avantageuse des feuilles intercalaires 20 portant des décors et ayant une température de ramollissement supérieure à la température de laminage. Les feuilles intercalaires 20 sont enduites de colle thermoactivable et peuvent être de préférence recouvertes de feuilles de protection transparentes 21.

Après réalisation de la cavité, le module 3 est implanté dans la carte, par exemple en disposant dans le fond de la cavité une faible quantité de colle 17 qui se répand dans l'intervalle entre le bloc de résine 8 et la paroi de la cavité 14. Lors de cette mise en place du module 3 dans le corps de carte, la matière conductrice 10 disposée dans les trous 9 du film support 4 s'écrase comme illustré par la figure 5 et assure un contact avec les plots de liaison 11, formant ainsi un organe conducteur entre les plages conductrices 18 et l'antenne 1. Comme illustré par la figure 5, les plots de connexion 10 écrasés débordent latéralement des trous 9 de sorte qu'ils assurent un contact suffisant avec les plots 11 même s'ils ne sont pas exactement en regard de ceux-ci lors de la mise en place du module. Lorsque la matière conductrice 10 est dans un état plastique avant la mise en place du module, on prévoit de préférence après mise en place un durcissement en température de la matière conductrice afin d'assurer une fiabilité supérieure de la connexion. On notera à ce propos que dans ce mode de réalisation les plages conductrices 18 qui sont reliées aux extrémités de l'antenne, bien qu'elles soient tournées vers l'extérieur du module, c'est-à-dire sur une face opposée au circuit intégré 6, peuvent ne pas être utilisées pour réaliser un contact avec une machine. Les plages conductrices 18 qui sont reliées à l'antenne servent alors seulement à effectuer un pontage entre les extrémités de l'antenne et les fils 19 correspondants.

La figure 7 illustre un second exemple dans lequel les plages conductrices 18 servant de pontage entre le circuit intégré 6 et les extrémités de l'antenne sont cette fois disposées sur la face du film support 4 portant le circuit intégré 6.

Dans ce cas le module comporte de préférence à l'aplomb des plages conductrices 18, des trous 22 qui permettent de mettre un outil chauffant en contact avec les plages conductrices 18 lors de la mise en place du module. Les plots de connexion 10 et les plots de liaison 11 qui servent à relier les plages conductrices 18 aux extrémités de l'antenne 1 sont alors avantageusement réalisés en matière conductrice fusible, par exemple une matière conductrice comportant des grains métalliques ayant des points de fusion différents comme décrit dans le document FR-A-2.726.001, ce qui permet de réaliser une soudure à chaud et d'obtenir une liaison présentant une résistance électrique particulièrement faible entre les plages conductrices et l'antenne.

Par ailleurs dans cet exemple le module est fixé par un cordon de colle 23 disposé dans le fond de la partie 16 de la cavité 14 en l'interrompant à l'aplomb des plots de liaison 11.

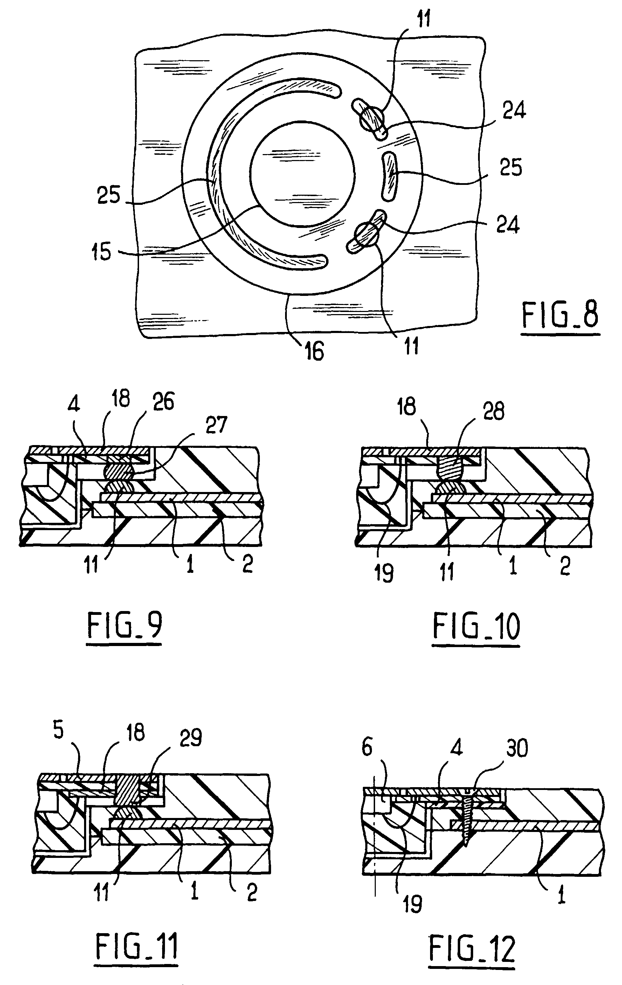

Ce mode de connexion peut aussi être réalisé en déposant une goutte de polymère conducteur sur l'extrémité du plot 11 apparaissant au fond de la cavité avant de fixer le module dans la cavité. Dans ce cas la plage conductrice 18 n'est pas pourvue d'un plot de connexion 10. Dans un cas comme dans l'autre et afin de délimiter l'emplacement de la colle ainsi que celui de la matière conductrice, des gorges sont de préférence réalisées dans le fond de la partie 16 de la cavité, comme illustré par la figure 8 qui est une vue de dessus de la cavité avant la mise en place du module. Des gorges 24 sont réalisées à cheval sur les extrémités des plots 11 et des gorges 25 sont réalisées de part et d'autre des gorges 24. La profondeur des gorges 24 et 25 est adaptée à la nature des produits qui sont utilisés afin que les surfaces en regard soient convenablement mouillées par les produits correspondants lors de la mise en place du module. En particulier lorsque la matière conductrice est fixée sur les plages de contact du module il est important que les gorges 24 soient plus profondes que les gorges 25 afin que la matière conductrice ne fasse pas obstacle à la mise en contact des parties du module en regard de la colle.

La figure 9 qui est une vue en coupe partielle de la carte au niveau de la liaison entre le module et le circuit de liaison de l'élément de couplage sans contact illustre une variante de ce mode de réalisation. Selon cette variante la plage conductrice 18 est portée par la face externe du film support 4 qui comporte alors des trous en regard des plots 11. Un plot conducteur 26, rigide ou en matière thermoplastique, est fixé dans les trous du film et est surfacé pour que sa face inférieure affleure la surface inférieure du film. La liaison entre le plot 26 et le plot 11 est assurée par une goutte de matière thermoplastique 27.

Dans l'exemple de la figure 5 comme dans celui de la figure 7, on peut également prévoir un ergot 10 en matière conductrice rigide qui est chauffé lors de la mise en place du module et s'enfonce alors dans un plot de liaison 11 en matière conductrice thermofusible.

La figure 10 illustre une autre variante dans laquelle la liaison entre la plage conductrice 18 et le plot 11 est assurée par un insert élastique conducteur 28, par exemple un insert en élastomère rendu conducteur dans la masse ou recouvert d'une pellicule conductrice ou de poudre conductrice.

La figure 11 illustre une autre variante de réalisation selon laquelle le film support 4 et la plage conductrice 18 sont percés d'un trou qui débouche sur la surface externe du module. Une goutte de polymère conducteur thermofusible ou un insert élastique conducteur 29 est disposé sur le plot 11 préalablement à la mise en place du module. Cette disposition permet, après mise en place du module, d'araser la matière conductrice qui déborde du trou à l'extérieur du module. Il est également possible d'introduire la matière conductrice (sous forme solide ou pâteuse) dans le trou après montage du module sur la carte.

Dans le cas de plages de contact 5 et 18 à l'aplomb l'une de l'autre comme illustré par la figure 11, il conviendra toutefois d'isoler le bord du trou dans la plage de contact 5 ou d'utiliser un élément conducteur n'atteignant pas la plage de contact 5 ou comportant une partie isolante en regard de la plage de contact 5 afin d'éviter un court-circuit entre les plages conductrices 5 et 18.

La figure 12 illustre un troisième exemple dans lequel l'antenne 1 n'est plus portée par une feuille support en résine époxy prise en sandwich entre deux feuilles thermoplastiques, mais est directement réalisée sur une feuille thermoplastique qu'il suffit donc de recouvrir sur la face comportant l'antenne avec une feuille de même nature pour obtenir un corps de carte en matière homogène.

En outre dans ce troisième exemple la liaison entre la plage conductrice 18 et l'antenne 1 est assurée par des organes conducteurs rigides, ici une vis 30 qui traverse la plage conductrice 18 et l'extrémité correspondante de l'antenne 1. Dans ce cas l'organe conducteur est mis en place après fixation du module dans la cavité de la carte.

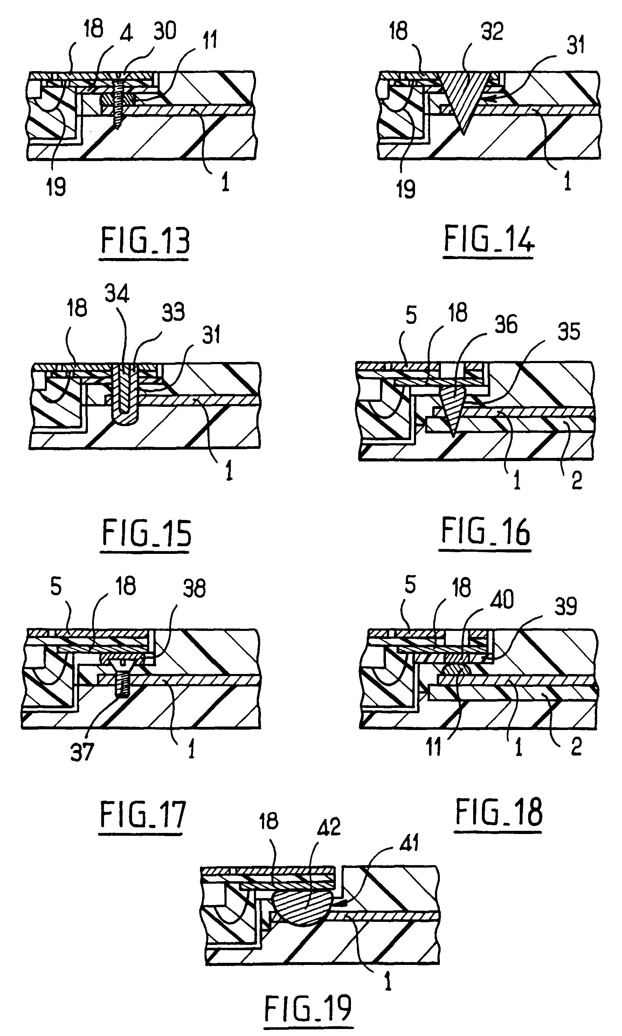

La figure 13 illustre une variante de réalisation dans laquelle ce mode de réalisation de la liaison par un organe rigide traversant les couches à relier est utilisé en relation avec une antenne 1 équipée d'un plot de connexion 11 en saillie sur l'antenne. On augmente ainsi la surface de contact entre la vis 30 et l'extrémité de l'antenne formant le circuit de liaison avec l'antenne.

La figure 14 illustre un mode de réalisation de l'invention selon lequel un organe conducteur est introduit dans un trou débouchant à la surface de la carte et traversant l'antenne sans que celle-ci ait été préalablement équipée d'un plot de connexion 11.

Dans ce mode de réalisation le module est mis en place avant d'effectuer une liaison comme dans le cas des figures 12 et 13 puis un trou 31 est réalisé à travers la partie du module et la partie de carte surplombant l'extrémité de l'antenne, et à travers cette extrémité, c'est-à-dire que les trous 31 traversent le circuit de liaison et les plages conductrices 18 associées. Le trou ainsi réalisé est rempli d'une matière conductrice qui peut être soit un insert rigide de forme correspondante enfoncé à force ou maintenu par un filet hélicoïdal, soit une matière conductrice introduite à l'état pâteux, soit une association d'un insert rigide avec une matière pâteuse, soit encore une matière élastique conductrice. Dans l'exemple de réalisation de la figure 14 le trou 31 est conique. Cette forme présente l'avantage d'augmenter la surface de contact de l'organe de liaison conducteur avec les plages conductrices qu'il traverse. En particulier, compte tenu de la très faible épaisseur des différentes couches traversées il est possible de réaliser industriellement un trou conique ayant un angle au sommet de 120°C, ce qui multiplie par deux la surface de contact avec les couches traversées.

En outre un trou conique permet une inspection visuelle de la qualité du trou réalisé avec une simple caméra afin de s'assurer notamment de l'absence de copeaux et de l'état de surface des couches conductrices traversées.

De plus un trou conique, ou plus généralement un trou borgne ayant une section croissante depuis le fond du trou jusqu'à une ouverture de celui-ci, permet un remplissage plus aisé qu'avec un trou cylindrique et assure un auto centrage de la matière conductrice insérée, que celle-ci soit rigide ou pâteuse ce qui permet d'augmenter la tolérance sur le positionnement des outils de mise en place de la matière conductrice.

Afin de masquer la matière conductrice on peut prévoir de recouvrir celle-ci d'une pastille métallique ou d'une encre de couleur analogue à celle de la surface de la carte à l'endroit où le trou débouche sur la surface de celle-ci.

Lorsque la matière conductrice est pâteuse on peut utiliser une matière déjà conductrice à l'état pâteux ou une matière rendue conductrice par chauffage ou après polymérisation.

La figure 15 illustre une variante de réalisation de ce type de liaison. Dans cette variante de réalisation le trou 31 est cylindrique et la matière conductrice remplissant le trou est une association d'une matière conductrice 33 introduite à l'état pâteux et d'un insert rigide 34 introduit dans la matière pâteuse. Cette solution combine les avantages de la faible résistivité de l'insert rigide et du bon contact de la matière pâteuse avec toutes les surfaces exposées. A ce propos on utilisera avantageusement l'encre conductrice décrite dans le document FR-A-2.726.001 précité en liaison avec un insert chauffé qui assurera la fusion des grains métalliques ayant le point de fusion le plus bas et comblera simultanément la réduction du volume résultant de cette fusion.

La figure 16 illustre un autre type de liaison selon un mode de réalisation de l'invention consistant à réaliser un trou 35 dans le corps de carte et à travers l'extrémité de l'antenne 1 après la réalisation de la cavité 14 mais avant le montage du module puis d'insérer dans ce trou un organe de liaison conducteur. Dans le mode de réalisation de la figure 16 le trou 35 est conique et l'organe de liaison se présente sous la forme d'un bloc de matière qui a été introduit à l'état pâteux puis polymérisé et qui est légèrement en saillie par rapport au fond de la cavité, sur une épaisseur (qui peut être contrôlée par usinage) sensiblement égale à l'épaisseur de l'adhésif servant à fixer le module dans la cavité. Lors du montage du module on assure donc simultanément la mise en contact du plot 36 avec la plage conductrice 18 du module. On peut également appliquer un poinçon chauffant à l'aplomb du plot 36 afin de parfaire sa connexion avec la plage conductrice 18. On peut également réaliser ce type de liaison en disposant un organe conducteur élastique dans le trou 35.

La figure 17 illustre une variante consistant à fixer un insert rigide, ici une vis 37 dans le fond de la cavité 14 de façon que l'insert 37 traverse l'extrémité de l'antenne 1 et s'étende légèrement en saillie par rapport au fond de la cavité, puis à recouvrir la partie en saillie de matière conductrice 38 afin de réaliser un bon contact avec la plage conductrice 18.

La figure 18 illustre un exemple utilisant un adhésif anisotrope 39 pour fixer le module dans une cavité dans laquelle débouche un plot de liaison 11 associé à une extrémité de l'antenne puis à soumettre l'adhésif à une pression localisée à l'aplomb du plot de liaison 11 afin de rendre conductrice la partie correspondante 40 de l'adhésif 39. Tout en utilisant un cordon continu de colle anisotrope ou une rondelle d'adhésif anisotrope qui assurent une fixation homogène du module, il est ainsi possible d'obtenir une conduction localisée.

La figure 19 illustre un mode de réalisation de l'invention dans lequel le trou 41 traversant le corps de carte et l'extrémité du circuit de liaison a une forme de calotte sphérique, ou plus généralement une section curviligne concave (qui pourrait être en forme de paraboloïde ou d'ellipsoïde. Une telle forme délimite un volume plus important qu'un trou conique ce qui permet d'augmenter la tolérance sur le volume de la goutte de matière conductrice 42 qui est introduite dans le trou tout en conservant une liaison satisfaisante entre le circuit de liaison et la plage conductrice 18 associée.

Bien entendu l'invention n'est pas limitée au mode de réalisation décrit et on peut y apporter des variantes de réalisation sans sortir du cadre de l'invention tel que défini par les revendications.

La feuille support 2 et les feuilles de recouvrement 13 sont de préférence réalisées sous forme de bande continue, éventuellement pourvues de perforations latérales non représentées, afin de réaliser une série de cartes par déplacements séquentiels des bandes à des postes de travail successifs.

## Revendications

1. Carte à circuit intégré à connexion mixte comportant un corps de carte dans lequel est noyé un circuit de liaison d'un élément de couplage sans contact (1) à un module comprenant un circuit intégré (6) relié à des plages conductrices portées par un film support (4), le circuit de liaison s'étendant à l'aplomb de plages conductrices (18) dédiées à une liaison sans contact et étant relié à celles-ci par une matière conductrice (32,36,42) disposée dans des trous (31,35,41) caractérisée en ce que les trous ont une section croissante depuis un fond des trous vers une ouverture de ceux-ci près des plages conductrices sur une partie au moins de leur hauteur.

2. Carte selon la revendication 1, caractérisée en ce que les trous traversent le circuit de liaison.

3. Carte selon la revendication 1, caractérisée en ce que les trous sont coniques.

4. Carte selon la revendication 3, caractérisée en ce que les trous coniques ont un angle au sommet de 120°.

5. Carte selon la revendication 1 caractérisée en ce que la matière conductrice (36,42) s'étend en saillie par rapport aux trous (35,41).

6. Carte selon la revendication 1, caractérisée en ce que les trous sont de forme curviligne concave.

7. Carte selon la revendication 6, caractérisée en ce que les trous sont hémisphériques.

8. Carte selon la revendication 1, caractérisée en ce que les trous (31) s'étendent à travers le film support.

9. Carte selon la revendication 1, caractérisée en ce qu'à l'aplomb des plages conductrices dédiées le film support comporte des trous borgnes (22) débouchant sur une face du module opposée au circuit intégré.

## Patentansprüche

1. Karte mit integriertem Schaltkreis und kombiniertem Anschluß umfassend einen Kartenkörper, in dem ein Verbindungskreis eingebettet ist, der ein kontaktloses Koppelelement (1) mit einem Modul verbindet, das eine integrierte Schaltung (6) enthält, die mit von einem Trägerfilm (4) getragenen leitenden Bereichen verbunden ist, wobei sich der Verbindungskreis in senkrechter Flucht mit leitenden Bereichen (18) erstreckt, die für eine kontaktlose Verbindung bestimmt sind, und mit diesen über ein leitendes Material (32, 36, 42) verbunden ist, das in Löchern (31, 35, 41) angeordnet ist, dadurch **gekennzeichnet**, daß die Löcher einen Querschnitt haben, der von einem Boden der Löcher in Richtung auf deren Öffnung nahe den leitenden Bereichen hin auf wenigstens einem Teil ihrer Höhe zunimmt.

2. Karte nach Anspruch 1, dadurch **gekennzeichnet**, daß die Löcher den Verbindungskreis durchsetzen.

3. Karte nach Anspruch 1, dadurch **gekennzeichnet**, daß die Löcher kegelförmig sind.

4. Karte nach Anspruch 3, dadurch **gekennzeichnet**, daß die kegelförmigen Löcher einen Spitzenwinkel von 120° haben.

5. Karte nach Anspruch 1, dadurch **gekennzeichnet**, daß das leitende Material (36, 42) über die Löcher (35, 41) hinausragt.

6. Karte nach Anspruch 1, dadurch **gekennzeichnet**, daß die Löcher eine gekrümmte, konkave Form haben.

7. Karte nach Anspruch 6, dadurch **gekennzeichnet**, daß die Löcher halbkugelförmig sind.

8. Karte nach Anspruch 1, dadurch **gekennzeichnet**, daß sich die Löcher (31) durch den Trägerfilm hindurch erstrecken.

9. Karte nach Anspruch 1, dadurch **gekennzeichnet**, daß der Trägerfilm in senkrechter Flucht mit den bestimmten leitenden Bereichen Blindlöcher (22) hat, die zu einer Seite des Moduls münden, die dem integrierten Schaltkreis entgegengesetzt ist.

## Claims

1. An integrated circuit card with two connection modes comprising a card body in which there is embedded a link circuit for linking a contactless coupling element (1) to a module comprising an integrated circuit (6) connected to conductive areas carried by a support film (4), the link circuit extending in register with conductive areas (18) dedicated to making a contactless link, and being connected thereto by a conductive material (32, 36, 42) disposed in holes (31, 35, 41), characterized in that the holes have a section that increases from a bottom of the holes towards an opening thereof adjacent the conductive areas over at least a portion of their height.

2. An integrated circuit card according to claim 1, characterized in that the holes extend through the link circuit.

3. An integrated circuit card according to claim 1, characterized in that the holes are conical.

4. An integrated circuit card according to claim 3, characterized in that the conical holes have an angle at the apex of 120°.

5. An integrated circuit card according to claim 1, characterized in that the conductive material (36, 42) projects from the holes (35, 41).

6. An integrated circuit card according to claim 1, characterized in that the holes are of concave curvilinear shape.

7. An integrated circuit card according to claim 6, characterized in that the holes are of hemispheric shape.

8. An integrated circuit card according to claim 1, characterized in that the holes (31) extend through the support film.

9. An integrated circuit card according to claim 1, characterized in that in register with the dedicated conductive areas the support film includes recessed holes (22) opening on a face of the module opposite to the integrated circuit.
